# EUROPEAN PATENT APPLICATION

(11) **EP 4 815 032 A1**
(43) Date of publication of application: **30.09.2026**
(21) Application number: 24910684.0
(22) Date of filing: 10.12.2024
(51) Int. Cl.: H01L 21/67, H01L 21/00

(54) **LOAD LOCK, SEMICONDUCTOR PROCESSING DEVICE AND WAFER ALIGNMENT METHOD**

(30) Priority: 26.12.2023 CN 202311811197
(71) Applicant: Beijing NAURA Microelectronics Equipment Co., Ltd., Beijing 100176 (CN)
(72) Inventor: LV, Chao, Beijing 100176 (CN); LI, Xue, Beijing 100176 (CN)
(74) Representative: Cohausz & Florack
(86) International application number: PCT/CN2024/138027
(87) International publication number: WO 2025/139753

(57) **Abstract**

The present disclosure provides a load lock, semiconductor process equipment, and a wafer calibration method. The load lock includes: a chamber body, a first carrier plate, a second carrier plate, a driving mechanism, and a stop member. The first carrier plate and the second carrier plate are oppositely arranged inside the chamber body, and the first carrier plate and the second carrier plate are configured to carry wafers. The driving mechanism is connected to the second carrier plate and is configured to drive the second carrier plate to move toward or away from the first carrier plate. During a process in which the second carrier plate moves toward the first carrier plate, the first carrier plate and the second carrier plate are configured to clamp a wafer to a calibration position. The present disclosure may effectively improve wafer transfer efficiency.

## Description

### TECHNICAL FIELD

The present disclosure relates to the technical field of semiconductor processes, and in particular relates to a load lock, semiconductor process equipment, and a wafer calibration method.

### BACKGROUND

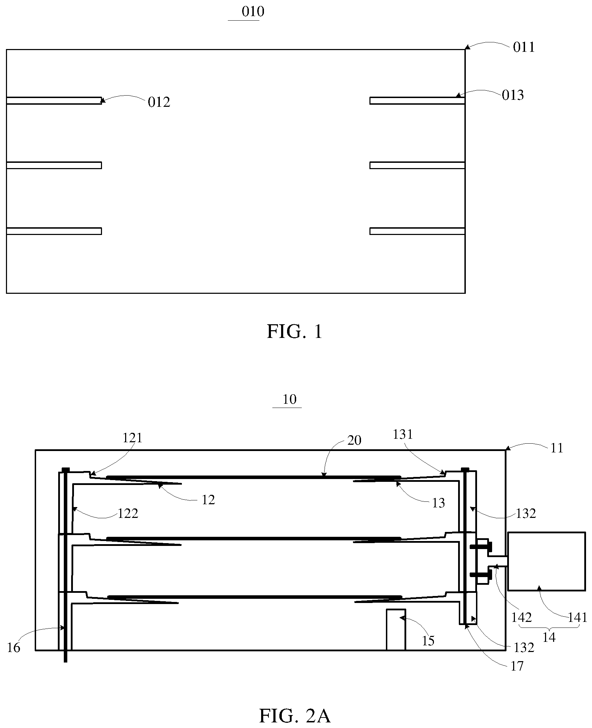

A load lock (load lock, abbreviated as LL), as an intermediate load lock for a wafer between an atmospheric environment and a vacuum environment, needs to be frequently switched between an atmospheric state and a vacuum state. As shown in FIG. 1, a first carrier plate 012 and a second carrier plate 013 opposite to each other are usually arranged inside a chamber body 011 of a load lock 010, and the first carrier plate 012 and the second carrier plate 013 are configured to carry wafers. When a wafer is transferred into or out of the chamber body 011 of the load lock 010 from an Equipment Front-End Module (Equipment Front-End Module, abbreviated as EFEM), the chamber body 011 is first vented to the atmospheric state, then an atmospheric-side valve of the load lock 010 is opened, and then the wafer is transferred into or out of the chamber body; when a wafer is transferred into or out of the chamber body 011 of the load lock 010 from a transport chamber (Transport Module, abbreviated as TM), the chamber body 011 is first evacuated to the vacuum state, then a vacuum-side valve of the load lock 010 is opened, and then the wafer is transferred into or out of the chamber body. However, since the wafer is prone to displacement inside the chamber body 011 of the load lock 010, calibration time consumption of the wafer during a subsequent transfer process is increased, resulting in relatively low wafer transfer efficiency.

### SUMMARY

The present disclosure provides a load lock, semiconductor process equipment, and a wafer calibration method, so as to solve the problem in the related art that wafer transfer efficiency is relatively low due to a wafer being prone to displacement inside a chamber body of the load lock.

According to a first aspect of the present disclosure, a load lock is provided, including: a chamber body; a first carrier plate and a second carrier plate oppositely arranged inside the chamber body, where the first carrier plate and the second carrier plate are configured to carry wafers; and a driving mechanism connected to the second carrier plate and configured to drive the second carrier plate to move toward or away from the first carrier plate. During a process in which the second carrier plate moves toward the first carrier plate, the first carrier plate and the second carrier plate are configured to clamp a wafer to a calibration position.

In one embodiment, the load lock further includes:
A stop member, located between the first carrier plate and the second carrier plate, and configured to abut against the second carrier plate during a process in which the second carrier plate moves toward the first carrier plate.

In one embodiment, the upper surface of the first carrier plate includes a first limiting surface, and the upper surface of the second carrier plate includes a second limiting surface; in a case where the first carrier plate and the second carrier plate clamp the wafer to the calibration position, both the first limiting surface and the second limiting surface abut against the peripheral edge of the wafer.

In one embodiment, the upper surface of the first carrier plate and the upper surface of the second carrier plate are each in a fan-ring shape, and the upper surface of the first carrier plate and the upper surface of the second carrier plate form an annular bearing surface having a notch, where the annular bearing surface inclines inwardly and downwardly along the radial direction of the annular bearing surface and is configured to support an edge region of the lower surface of the wafer.

In one embodiment, there are a plurality of first carrier plates and a plurality of second carrier plates, the plurality of first carrier plates and the plurality of second carrier plates are spaced apart along the vertical direction, and the plurality of first carrier plates correspond one-to-one to the plurality of second carrier plates and are configured to carry a plurality of wafers.

In one embodiment, the driving mechanism includes a cylinder and a telescopic rod, a first end of the telescopic rod is connected to the cylinder, and a second end of the telescopic rod is connected to the second carrier plate; the cylinder drives the telescopic rod to extend and retract so as to drive the second carrier plate to move; or, the driving mechanism includes a motor and a motor shaft, a first end of the motor shaft is connected to the motor, and a second end of the motor shaft is connected to the second carrier plate; the motor drives the motor shaft to extend and retract so as to drive the second carrier plate to move.

According to a second aspect of the present disclosure, semiconductor process equipment is provided, including an Equipment Front-End Module, a transport chamber, a process chamber, and at least one group of load locks according to any one of the above embodiments; each group of load locks includes a first load lock and a second load lock adjacently arranged along the horizontal direction, and the first load lock and the second load lock are both connected between the Equipment Front-End Module and the transport chamber; the process chamber is connected to the transport chamber, and a plurality of bases are arranged inside the process chamber; in a case where the first carrier plate and the second carrier plate in the first load lock clamp the wafer to the calibration position, and the first carrier plate and the second carrier plate in the second load lock clamp the wafer to the calibration position, the relative positional relationship between the wafer in the first load lock and the wafer in the second load lock is adapted to the relative positional relationship between two adjacent bases.

In one embodiment, there are two groups of load locks, and the two groups of load locks are stacked along the vertical direction; one group of load locks is used as an intermediate load lock for transferring wafers from the Equipment Front-End Module to the transport chamber; and another group of load locks is used as an intermediate load lock for transferring wafers from the transport chamber to the Equipment Front-End Module.

According to a third aspect of the present disclosure, a wafer calibration method is provided and applied to the load lock according to any one of the above embodiments, where the load lock is provided with a gas inlet assembly and a gas evacuation assembly, and the method includes: when the wafer is placed on the first carrier plate and the second carrier plate in the load lock, controlling the gas inlet assembly to introduce gas into the interior of the chamber body of the load lock or controlling the gas evacuation assembly to evacuate gas from the interior of the chamber body of the load lock; and during a process of controlling gas introduction or gas evacuation, controlling the driving mechanism to drive the second carrier plate to move toward the first carrier plate.

In one embodiment, the method further includes: after controlling the wafer to move out of the load lock, controlling the driving mechanism to drive the second carrier plate to move away from the first carrier plate.

Advantages or beneficial effects of the above technical solutions at least include: the driving mechanism drives the second carrier plate to move toward or away from the first carrier plate, such that when the second carrier plate is away from the first carrier plate, the first carrier plate and the second carrier plate are suitable for placing a wafer thereon, and when the second carrier plate approaches the first carrier plate, the first carrier plate and the second carrier plate can clamp the carried wafer to the calibration position, thereby achieving position calibration of the wafer. In view of this, position calibration may be performed on the wafer inside the chamber body of the load lock, so as to ensure that the wafer is moved out of the load lock from the calibration position, which is beneficial to reducing calibration time consumption of the wafer during a subsequent transfer process, thereby improving transfer efficiency.

### BRIEF DESCRIPTION OF THE DRAWINGS

The accompanying drawings herein are incorporated into and constitute a part of this specification, illustrate embodiments consistent with the present disclosure, and together with the specification are used to explain the principles of the present disclosure. In addition, these drawings and written descriptions are not intended to limit the scope of the concepts of the present disclosure in any manner, but are intended to illustrate the concepts of the present disclosure to those skilled in the art by reference to specific embodiments.
FIG. 1 is a schematic structural diagram of a load lock in the related art.
FIG. 2A is a schematic structural diagram of a load lock when the second carrier plate is away from the first carrier plate according to an embodiment of the present disclosure.
FIG. 2B is a schematic structural diagram of a load lock when the second carrier plate approaches the first carrier plate according to an embodiment of the present disclosure.
FIG. 2C is a schematic cross-sectional structural diagram of the first carrier plate and the second carrier plate in FIG. 2A.
FIG. 2D is a schematic top view of the load lock in FIG. 2A.
FIG. 3 is a schematic diagram of a calibration process inside a process chamber in the related art.
FIG. 4 is a schematic structural diagram of semiconductor process equipment according to an embodiment of the present disclosure.
FIG. 5 is a schematic arrangement diagram of one group of load locks in FIG. 4.
FIG. 6 is a schematic arrangement diagram of two groups of load locks in FIG. 4.

### DETAILED DESCRIPTION OF THE EMBODIMENTS

Only some exemplary embodiments are briefly described in the following. As may be recognized by those skilled in the art, the described embodiments may be modified in various different ways without departing from the spirit or scope of the present disclosure. Therefore, the drawings and descriptions are considered to be illustrative in nature rather than restrictive.

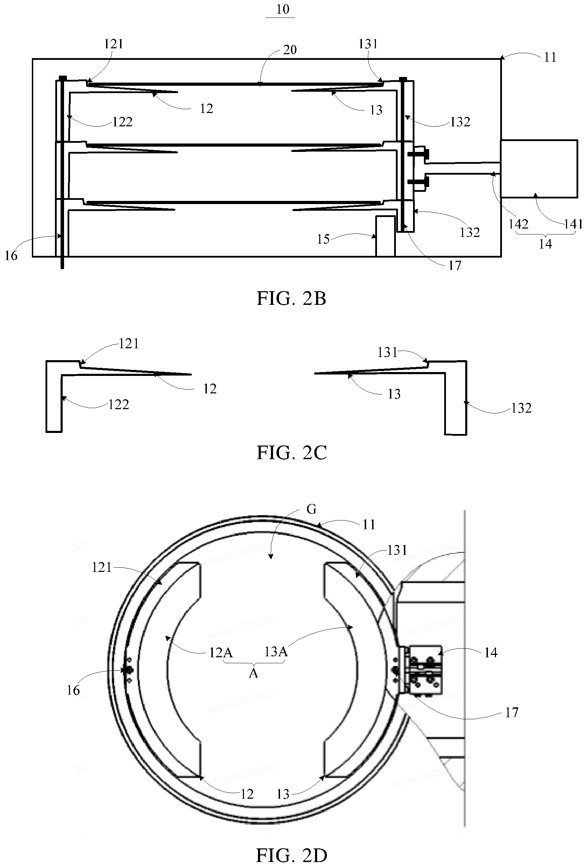

FIG. 2A is a schematic structural diagram of a load lock when the second carrier plate is away from the first carrier plate according to an embodiment of the present disclosure. FIG. 2B is a schematic structural diagram of a load lock when the second carrier plate approaches the first carrier plate according to an embodiment of the present disclosure. FIG. 2C is a schematic cross-sectional structural diagram of the first carrier plate and the second carrier plate in FIG. 2A. FIG. 2D is a schematic top view of the load lock in FIG. 2A.

Referring together to FIG. 2A to FIG. 2D, the load lock 10 includes a chamber body 11, a first carrier plate 12, a second carrier plate 13, a driving mechanism 14, and a stop member 15.

The first carrier plate 12 and the second carrier plate 13 are oppositely arranged inside the chamber body 11, and the first carrier plate 12 and the second carrier plate 13 are configured to carry a wafer 20.

The driving mechanism 14 is connected to the second carrier plate 13 and is configured to drive the second carrier plate 13 to move toward or away from the first carrier plate 12.

During a process in which the second carrier plate 13 moves toward the first carrier plate 12, the first carrier plate 12 and the first carrier plate 12 are configured to clamp the wafer 20 to a calibration position.

In the load lock 10 provided by the embodiment of the present disclosure, the driving mechanism 14 drives the second carrier plate 13 to move toward or away from the first carrier plate 12, such that when the second carrier plate 13 is away from the first carrier plate 12, the first carrier plate 12 and the second carrier plate 13 are suitable for placing the wafer 20 thereon, and when the second carrier plate 13 approaches the first carrier plate 12, the first carrier plate 12 and the second carrier plate 13 may clamp the carried wafer 20 to the calibration position, thereby achieving position calibration of the wafer 20. In view of this, position calibration may be performed on the wafer 20 inside the chamber body 11 of the load lock 10, so as to ensure that the wafer 20 is moved out of the load lock 10 from the calibration position, which is beneficial to reducing calibration time consumption of the wafer 20 during a subsequent transfer process, thereby improving transfer efficiency.

For example, when the driving mechanism 14 drives the second carrier plate 13 to move toward a direction away from the first carrier plate 12, the distance between the first carrier plate 12 and the second carrier plate 13 increases, and the area of a region enclosed by the first carrier plate 12 and the second carrier plate 13 increases, such that the wafer 20 is easily placed on the first carrier plate 12 and the second carrier plate 13. When the driving mechanism 14 drives the second carrier plate 13 to move toward a direction approaching the first carrier plate 12, the distance between the second carrier plate 13 and the first carrier plate 12 decreases, the area of the region enclosed by the first carrier plate 12 and the second carrier plate 13 decreases, and the first carrier plate 12 and the second carrier plate 13 may clamp the wafer 20 to the calibration position, thereby achieving position calibration of the wafer 20.

For example, in practical applications, the calibration position inside the chamber body 11 of the load lock 10 is adapted to a wafer pickup position of a vacuum manipulator, the calibration position inside the process chamber is adapted to a wafer placement position of the vacuum manipulator, and a wafer transfer path after the vacuum manipulator clamps the wafer 20 connects the wafer pickup position and the wafer placement position; if the wafer 20 is displaced inside the chamber body 11 of the load lock 10, after the vacuum manipulator removes the wafer 20 from inside the chamber body 11 of the load lock 10 and transfers the wafer 20 to the inside of the process chamber, a calibration operation needs to be performed on the wafer 20 during a wafer placement process, such that more calibration time is consumed during the transfer process of the wafer 20. In the present disclosure, by performing position calibration on the wafer 20 inside the chamber body 11 of the load lock 10, the wafer 20 may be located at the calibration position, thereby facilitating the vacuum manipulator to accurately transfer the wafer 20 to the inside of the process chamber after removing the wafer 20 from inside the chamber body 11 of the load lock 10, such that the vacuum manipulator does not need to perform a calibration operation on the wafer 20 during the wafer placement process, thereby effectively reducing calibration time consumption of the wafer 20 during the subsequent transfer process.

During a process in which the second carrier plate 13 moves toward a direction away from the first carrier plate 12, there may be various ways to stop the second carrier plate 13 at a position where the wafer 20 is clamped to the calibration position. For example, the stroke of the second carrier plate 13 may be controlled through the driving mechanism, or a movement end position of the second carrier plate 13 may be controlled through a position sensor. Further, the second carrier plate 13 may also be prevented from continuing to move through a mechanical structure, so as to stop the second carrier plate 13 at the position where the wafer 20 is clamped to the calibration position.

In some embodiments, there may be various mechanical structures for implementing the above functions. For example, the load lock 10 further includes a stop member 15, and the stop member 15 is located between the first carrier plate 12 and the second carrier plate 13 and is configured to abut against the second carrier plate 13 when the second carrier plate 13 moves toward the first carrier plate 12 until the first carrier plate 12 and the second carrier plate 13 clamp the wafer 20 to the calibration position. Exemplarily, the stop member 15 is further arranged at the bottom of the chamber body 11, and when the second carrier plate 13 moves toward the first carrier plate 12 until the first carrier plate 12 and the second carrier plate 13 clamp the wafer 20 to the calibration position, the bottom of the second carrier plate 13 abuts against the stop member 15.

Exemplarily, when the driving mechanism 14 drives the second carrier plate 13 to move toward a direction away from the first carrier plate 12, the distance between the first carrier plate 12 and the second carrier plate 13 increases, and the area of a region enclosed by the first carrier plate 12 and the second carrier plate 13 increases, such that the wafer 20 is easily placed on the first carrier plate 12 and the second carrier plate 13. When the driving mechanism 14 drives the second carrier plate 13 to move toward a direction approaching the first carrier plate 12, the distance between the second carrier plate 13 and the first carrier plate 12 decreases, the area of the region enclosed by the first carrier plate 12 and the second carrier plate 13 decreases, until the second carrier plate 13 abuts against the stop member 15, and the first carrier plate 12 and the second carrier plate 13 may clamp the wafer 20 to the calibration position, thereby achieving position calibration of the wafer 20.

In the load lock 10 provided by the embodiment of the present disclosure, the driving mechanism 14 drives the second carrier plate 13 to move toward or away from the first carrier plate 12, such that when the second carrier plate 13 is away from the first carrier plate 12, the first carrier plate 12 and the second carrier plate 13 are suitable for placing the wafer 20 thereon, and when the second carrier plate 13 approaches the first carrier plate 12 and abuts against the stop member 15, the first carrier plate 12 and the second carrier plate 13 may clamp the carried wafer 20 to the calibration position, thereby achieving position calibration of the wafer 20. In view of this, position calibration may be performed on the wafer 20 inside the chamber body 11 of the load lock 10, so as to ensure that the wafer 20 is moved out of the load lock 10 from the calibration position, which is beneficial to reducing calibration time consumption of the wafer 20 during the subsequent transfer process, thereby improving transfer efficiency.

In one embodiment, as shown in FIG. 2A and FIG. 2B, the upper surface of the first carrier plate 12 has a first limiting surface 121, and the upper surface of the second carrier plate 13 has a second limiting surface 131; in a case where the first carrier plate 12 and the second carrier plate 13 clamp the wafer 20 to the calibration position, for example, in a case where the second carrier plate 13 abuts against the stop member 15, both the first limiting surface 121 and the second limiting surface 131 abut against the peripheral edge of the wafer 20. Based on this, during a process in which the second carrier plate 13 moves toward the first carrier plate 12, the wafer 20 may be driven to move through the second limiting surface 131 abutting against the peripheral edge of the wafer 20, and in a case where the first carrier plate 12 and the second carrier plate 13 clamp the wafer 20 to the calibration position, for example, in a case where the second carrier plate 13 abuts against the stop member 15, the first limiting surface 121 and the second limiting surface 131 may jointly abut against the peripheral edge of the wafer 20 so as to clamp the wafer 20 and limit the wafer 20 at a specific calibration position, thereby helping improve the accuracy of position calibration.

In one embodiment, as shown in FIG. 2C and FIG. 2D, the upper surface 12A of the first carrier plate 12 and the upper surface 13A of the second carrier plate 13 are each in a fan-ring shape, and the upper surface 12A of the first carrier plate 12 and the upper surface 13A of the second carrier plate 13 form an annular bearing surface A having a notch G. The annular bearing surface A inclines inwardly and downwardly along the radial direction of the annular bearing surface A and is configured to support an edge region of the lower surface of the wafer 20.

According to the above solution, by configuring the upper surface 12A of the first carrier plate 12 and the upper surface 13A of the second carrier plate 13 to each be in a fan-ring shape, and configuring the upper surface 12A of the first carrier plate 12 and the upper surface 13A of the second carrier plate 13 to form the annular bearing surface A having the notch G, the shape of the annular bearing surface A may be adapted to the shape of the wafer 20; and by configuring the annular bearing surface A to incline inwardly and downwardly along the radial direction of the annular bearing surface A, when the annular bearing surface A supports the wafer 20, the annular bearing surface A only contacts the edge region of the lower surface of the wafer 20, thereby effectively reducing the contact area between the wafer 20 and the annular bearing surface A, and thus reducing particles generated due to friction between the wafer 20 and the annular bearing surface A.

In one embodiment, as shown in FIG. 2A and FIG. 2B, there are a plurality of first carrier plates 12 and a plurality of second carrier plates 13, the plurality of first carrier plates 12 and the plurality of second carrier plates 13 are spaced apart along the vertical direction, and the plurality of first carrier plates 12 and the plurality of second carrier plates 13 are arranged in one-to-one correspondence and are configured to carry a plurality of wafers 20.

Exemplarily, a first support part 122 is arranged at the bottom of the first carrier plate 12, a plurality of first support parts 122 are stacked along the vertical direction and connected to the bottom of the chamber body 11 through first fastener 16 passing through the plurality of first support parts 122, so that the plurality of first carrier plates 12 may be spaced apart along the vertical direction. On the basis of supporting and fixing the first carrier plates 12, the first support parts 122 may further maintain a certain distance between two adjacent first carrier plates 12, so as to facilitate wafer loading and unloading operations. A second support part 132 is arranged at the bottom of the second carrier plate 13, a plurality of second support parts 132 are stacked along the vertical direction and connected to each other through second fastener 17 passing through the plurality of second support parts 132, so that the plurality of second carrier plates 13 may be spaced apart along the vertical direction. On the basis of supporting and fixing the second carrier plates 13, the first support parts 122 may further maintain a certain distance between two adjacent second carrier plates 13, so as to facilitate wafer loading and unloading operations. The first fastener 16 and the second fastener 17 include, but are not limited to, screws. The plurality of first carrier plates 12 and the plurality of second carrier plates 13 are in one-to-one correspondence, so that a plurality of wafers 20 may be simultaneously placed inside the chamber body 11. In this way, when the driving mechanism 14 synchronously drives the plurality of second carrier plates 13 to move toward a direction approaching the first carrier plate 12, the plurality of first carrier plates 12 and the plurality of second carrier plates 13 may clamp the plurality of wafers 20 at calibration positions in one-to-one correspondence, so that position calibration may be simultaneously performed on the plurality of wafers 20, thereby helping improve calibration efficiency.

In some embodiments, as shown in FIG. 2A and FIG. 2B, the driving mechanism 14 includes a cylinder 141 and a telescopic rod 142. A first end of the telescopic rod 142 is connected to the cylinder 141, and a second end of the telescopic rod 142 is connected to the second carrier plate 13. The cylinder 141 drives the telescopic rod 142 to extend and retract so as to drive the second carrier plate 13 to move.

Exemplarily, the cylinder 141 may be arranged at an outer side wall of the chamber body 11 adjacent to the second carrier plate 13, the first end of the telescopic rod 142 is connected to a side of the cylinder 141 facing the chamber body 11, and the second end of the telescopic rod 142 passes through the outer side wall of the chamber body 11 and is connected to the second carrier plate 13. The second end of the telescopic rod 142 may be fixedly connected to the second carrier plate 13 through fasteners such as rivets or screws. When the cylinder 141 drives the telescopic rod 142 to retract, the telescopic rod 142 drives the second carrier plate 13 to move toward a direction away from the first carrier plate 12; and when the cylinder 141 drives the telescopic rod 142 to extend, the telescopic rod 142 drives the second carrier plate 13 to move toward a direction approaching the first carrier plate 12. Based on this, driving of the second carrier plate 13 by the driving mechanism 14 may be achieved.

In some other embodiments, the driving mechanism 14 includes a motor and a motor shaft (not shown in the drawings). A first end of the motor shaft is connected to the motor, and a second end of the motor shaft is connected to the second carrier plate 13. The motor drives the motor shaft to extend and retract so as to drive the second carrier plate 13 to move.

Exemplarily, the motor may be arranged at an outer side wall of the chamber body 11 adjacent to the second carrier plate 13, the first end of the motor shaft is connected to a side of the cylinder 141 facing the chamber body 11, and the second end of the motor shaft passes through the outer side wall and is connected to the second carrier plate 13. The motor drives the motor shaft to extend and retract so as to drive the second carrier plate 13 to move. The principle of the motor driving the motor shaft to extend and retract is the same as the principle of the cylinder 141 driving the telescopic rod 142 to extend and retract, and details are not described herein again.

It should be noted that arrangement positions of the cylinder 141 and the motor may also be selected and adjusted according to actual needs, and the embodiments of the present disclosure are not limited thereto.

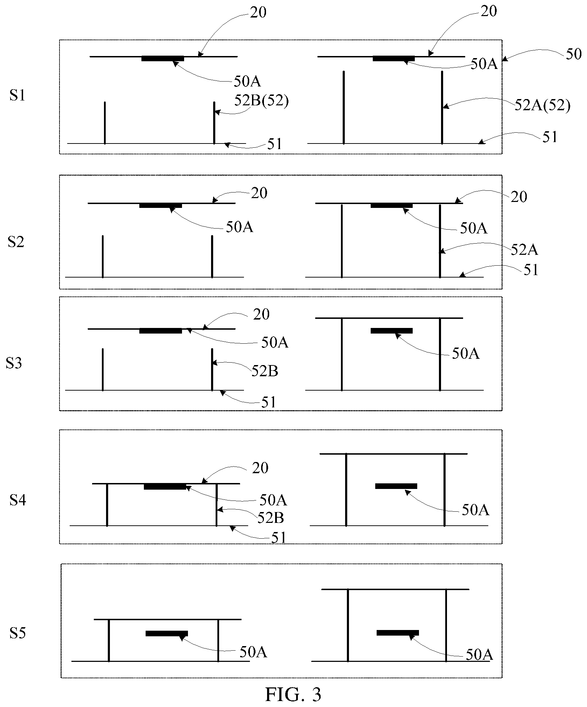

In the related art, in order to improve wafer transfer efficiency, two load locks are usually connected between the Equipment Front-End Module and the transport chamber, two bases are arranged inside the process chamber, and a vacuum manipulator may take out one wafer from each of the two load locks at one time, such that the vacuum manipulator may simultaneously transfer the two wafers onto the two bases inside the process chamber. For example, as shown in FIG. 3, the vacuum manipulator 50A is usually a single-layer dual-arm manipulator, and two lifting mechanisms (not shown in the drawings) inside the process chamber 50 lift two groups of thimbles 52 to different heights (operation S1), so as to ensure that there are different height differences between the two wafers 20 simultaneously clamped by the vacuum manipulator 50A and the two groups of thimbles 52, thereby enabling the vacuum manipulator 50A to respectively calibrate and place the two wafers 20 by using the height differences. For example, the height of the first group of thimbles 52A located at the right side is higher than the height of the second group of thimbles 52B located at the left side, the vacuum manipulator 50A first clamps the two wafers 20 at the same height (operation S1); then aligns the wafer 20 on the right side with the base 51 on the right side and places the wafer 20 on the first group of thimbles 52A on the right side (operation S2), during which the vacuum manipulator 50A simultaneously clamps the wafer 20 on the left side and moves downward; next, during the descending process, the vacuum manipulator 50A continues to align the wafer 20 on the left side with the base 51 on the left side and places the wafer 20 on the second group of thimbles 52B on the left side (operation S3 to operation S4); and then the vacuum manipulator 50A descends by a certain height and moves out of the process chamber 50 (operation S5). However, since the wafer is prone to position displacement inside the chamber body of the load lock, when the vacuum manipulator located inside the transport chamber transfers the two wafers from the load locks onto the two bases inside the process chamber, position calibration needs to be respectively performed on the two wafers, thereby reducing wafer transfer efficiency.

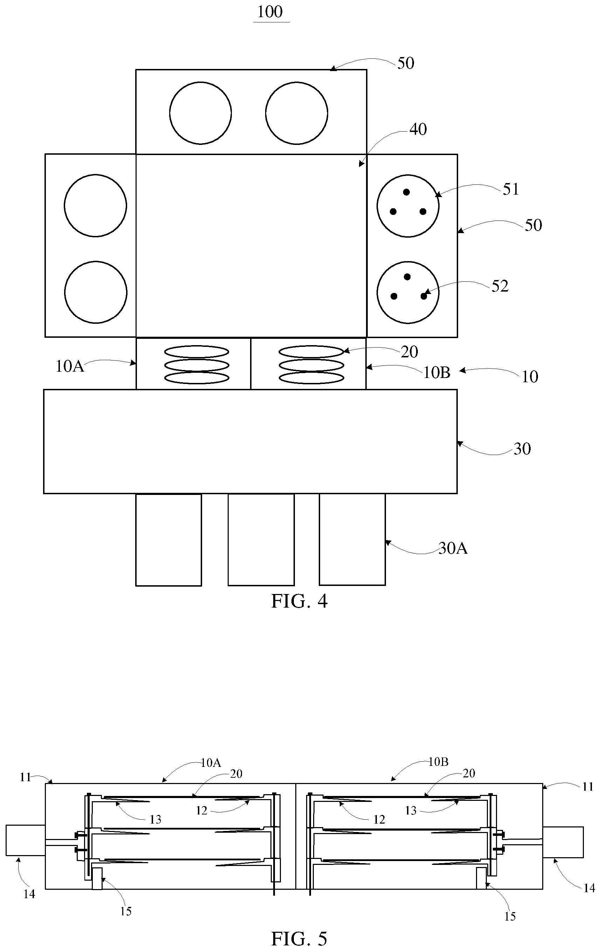

In view of this, the embodiments of the present disclosure further provide semiconductor process equipment. As shown in FIG. 4 and FIG. 5, the semiconductor process equipment 100 includes an Equipment Front-End Module 30, a transport chamber 40, a process chamber 50, and at least one group of the load locks 10 according to any one of the above embodiments. Each group of load locks 10 includes a first load lock 10A and a second load lock 10B adjacently arranged along the horizontal direction, and the first load lock 10A and the second load lock 10B are both connected between the Equipment Front-End Module 30 and the transport chamber 40. The process chamber 50 is connected to the transport chamber 40, and a plurality of bases 51 are arranged inside the process chamber 50. In a case where the first carrier plate 12 and the second carrier plate 13 in the first load lock 10A clamp the wafer 20 to the calibration position, and the first carrier plate 12 and the second carrier plate 13 in the second load lock 10B clamp the wafer 20 to the calibration position, for example, in an embodiment provided with the stop member 15, in a case where the second carrier plate 13 in the first load lock 10A abuts against the stop member 15 and the second carrier plate 13 in the second load lock 10B abuts against the stop member 15, the relative positional relationship between the wafer 20 in the first load lock 10A and the wafer 20 in the second load lock 10B is adapted to the relative positional relationship between any two adjacent bases 51 inside the process chamber 50.

An atmospheric manipulator is arranged inside the Equipment Front-End Module 30, and a loading chamber 30A for placing wafers 20 is arranged at a side of the Equipment Front-End Module 30 away from the load lock 10. The atmospheric manipulator may transfer the wafers 20 inside the loading chamber 30A into the chamber body 11 of the load lock 10, and may also transfer the wafers 20 inside the chamber body 11 of the load lock 10 back into the loading chamber 30A.

According to the above solution, by arranging the first load lock 10A and the second load lock 10B between the Equipment Front-End Module 30 and the transport chamber 40, after the two wafers 20 are correspondingly transferred into the chamber body 11 of the first load lock 10A and the chamber body 11 of the second load lock 10B, the first carrier plate 12 and the second carrier plate 13 in the first load lock 10A clamp the wafer 20 to the calibration position, and the first carrier plate 12 and the second carrier plate 13 in the second load lock 10B clamp the wafer 20 to the calibration position. For example, in a case where the second carrier plate 13 in the first load lock 10A abuts against the stop member 15 and the second carrier plate 13 in the second load lock 10B abuts against the stop member 15, position calibration may be correspondingly performed on the two wafers 20. Further, because after corresponding position calibration is performed on the two wafers 20, the relative positional relationship between the two wafers 20 is adapted to the relative positional relationship between any two adjacent bases 51 inside the process chamber 50, when the vacuum manipulator inside the transport chamber 40 transfers the two wafers 20 into the process chamber 50, only one wafer 20 needs to undergo position calibration to ensure that the two wafers 20 are aligned one-to-one with any two adjacent bases 51, thereby reducing position calibration time consumption inside the process chamber 50 and helping improve transfer efficiency of the wafers 20, for example, increasing the number of wafers 20 transferred per hour.

In addition, it should be noted that, as shown in FIG. 3, in the related art, two lifting mechanisms inside the process chamber 50 usually lift two groups of thimbles 52 to different heights, so as to ensure that there are different height differences between the two wafers 20 simultaneously clamped by the vacuum manipulator 50A and the two groups of thimbles 52, thereby enabling the vacuum manipulator 50A to respectively calibrate and place the two wafers 20. Such a structure needs a three-stage lifting mechanism to satisfy lifting the two groups of thimbles 52 to different heights, and further needs the valve height of the process chamber 50 to be set relatively high so as to satisfy the stroke requirement of the vacuum manipulator 50A for calibrating and placing the wafers 20, thereby increasing the design difficulty of the calibration function inside the process chamber 50. In order to solve this problem, in the embodiments of the present disclosure, as shown in FIG. 4 and FIG. 5, since the first load lock 10A and the second load lock 10B have calibration functions, after the two wafers 20 undergo position calibration through the first load lock 10A and the second load lock 10, the relative positional relationship between the two wafers 20 may be calibrated in advance, such that the relative positional relationship between the two wafers 20 is adapted to the relative positional relationship between any two adjacent bases 51 inside the process chamber 50. For example, the distance between the two wafers 20 is equal to the distance between any two adjacent bases 51, which is equivalent to replacing part of the calibration function of the process chamber 50 in the related art. In this way, when the vacuum manipulator 50A simultaneously moves the two wafers 20 into the process chamber 50, only one wafer 20 needs to undergo position calibration to ensure that the two wafers 20 are aligned one-to-one with any two adjacent bases 51, such that the calibration function of the process chamber 50 may be achieved without relying on the two lifting mechanisms to lift the two groups of thimbles 52 to different heights. For example, the calibration function of the process chamber 50 may also be achieved when the two lifting mechanisms lift the two groups of thimbles 52 to the same height. This is also beneficial to shortening the stroke of the vacuum manipulator 50A for calibrating and placing the wafers 20, thereby enabling the valve height of the process chamber 50 to be set relatively lower and reducing the design difficulty of the calibration function inside the process chamber 50.

In one example, as shown in FIG. 5, the second carrier plate 13 and the driving mechanism 14 of the first load lock 10A are both located at a side of the first load lock 10A away from the second load lock 10B, and the second carrier plate 13 and the driving mechanism 14 of the second load lock 10B are both located at a side of the second load lock 10B away from the first load lock 10A. Such an arrangement manner enables sides of the first load lock 10A and the second load lock 10B adjacent to each other to closely abut against each other, which is beneficial to saving arrangement space.

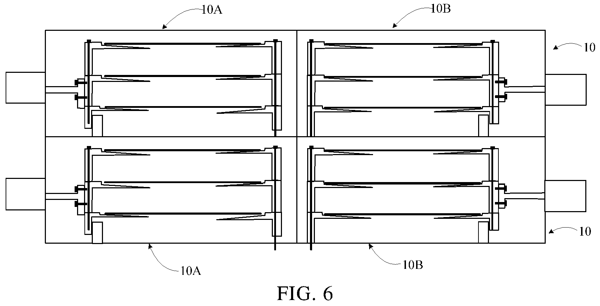

In one embodiment, referring together to FIG. 4 and FIG. 6, the load locks 10 include two groups, and the two groups of load locks 10 are stacked along the vertical direction; one group of load locks 10 is used as an intermediate load lock for transferring wafers 20 from the Equipment Front-End Module 30 to the transport chamber 40, for example, the group of load locks 10 located at the upper layer; and the other group of load locks 10 is used as an intermediate load lock for transferring wafers 20 from the transport chamber 40 to the Equipment Front-End Module 30, for example, the group of load locks 10 located at the lower layer.

According to the above solution, by configuring one group of the two groups of load locks 10 as intermediate load locks for transferring wafers 20 from the Equipment Front-End Module 30 to the transport chamber 40, and configuring the other group of load locks 10 as intermediate load locks for transferring wafers 20 from the transport chamber 40 to the Equipment Front-End Module 30, the transfer process in which the wafers 20 are transferred from the Equipment Front-End Module 30 into the transport chamber 40 and the return process in which the wafers 20 are returned from the transport chamber 40 to the Equipment Front-End Module 30 may not interfere with each other, which is beneficial to improving transfer efficiency of the wafers 20.

The present disclosure further provides a wafer calibration method, and the method is applied to the load lock 10 according to any one of the above embodiments, where the load lock 10 is provided with a gas inlet assembly and a gas evacuation assembly (not shown in the drawings). Referring together to FIG. 2A and FIG. 2B, the method includes the following operations S110 to S120.

Operation S110: under a condition that the wafer 20 is placed on the first carrier plate 12 and the second carrier plate 13 in the load lock 10, control the gas inlet assembly to vent the interior of the chamber body 11 of the load lock 10 or control the gas evacuation assembly to evacuate gas from the interior of the chamber body 11 of the load lock 10.

Operation S120: during a process of controlling gas introduction or gas evacuation, control the driving mechanism 14 to drive the second carrier plate 13 to move toward a direction approaching the first carrier plate 12.

Referring together to FIG. 4, in practical applications, before the wafer 20 is transferred from the interior of the chamber body 11 of the load lock 10 to the transport chamber 40, the interior of the chamber body 11 of the load lock 10 is first evacuated to a vacuum state, such that the state inside the chamber body 11 of the load lock 10 is consistent with the state inside the transport chamber 40, and then the wafer 20 is taken out from the interior of the chamber body 11 of the load lock 10; and before the wafer 20 is returned from the interior of the chamber body 11 of the load lock 10 to the Equipment Front-End Module 30, the interior of the chamber body 11 of the load lock 10 is first vented to an atmospheric state, such that the state inside the chamber body 11 of the load lock 10 is consistent with the state inside the Equipment Front-End Module 30, and then the wafer 20 is taken out from the interior of the chamber body 11 of the load lock 10.

According to the above solution, during the process of controlling gas introduction or gas evacuation, the driving mechanism 14 is simultaneously controlled to drive the second carrier plate 13 to move toward a direction approaching the first carrier plate 12, so that position calibration may be performed on the wafer 20 placed on the first carrier plate 12 and the second carrier plate 13, such that the position calibration of the wafer 20 is synchronously performed with the gas introduction or gas evacuation process. In this way, the position calibration of the wafer 20 does not consume additional time, which is beneficial to improving calibration efficiency of the wafer 20. In addition, during the process of controlling gas evacuation, performing position calibration on the wafer 20 is more beneficial to reducing a risk of position displacement of the wafer 20 during the return process.

In one embodiment, referring together to FIG. 2A and FIG. 2B, the method further includes: after controlling the wafer 20 to move out of the load lock 10, controlling the driving mechanism 14 to drive the second carrier plate 13 to move toward a direction away from the first carrier plate 12. Based on this, under a condition that no wafer 20 is placed on the first carrier plate 12 and the second carrier plate 13, controlling the second carrier plate 13 to move away from the first carrier plate 12 may enable the first carrier plate 12 and the second carrier plate 13 to be in a state suitable for placing the wafer 20 thereon, thereby facilitating advance preparation for a subsequent transfer process.

In the present disclosure, unless otherwise expressly specified and limited, terms such as "connected," "connection," and "stacked" should be broadly understood. For example, the connection may be a fixed connection, a detachable connection, or an integrated connection; the connection may be a direct connection or an indirect connection through an intermediate medium; and the connection may be internal communication between two elements or an interaction relationship between two elements. Those of ordinary skill in the art may understand specific meanings of the above terms in the present disclosure according to specific circumstances.

In the description of this specification, descriptions with reference to terms such as "one embodiment," "some embodiments," "example," "specific example," or "some examples" indicate that specific features, structures, materials, or characteristics described in connection with the embodiment or example are included in at least one embodiment or example of the present disclosure. Moreover, the specific features, structures, materials, or characteristics described may be combined in any one or more embodiments or examples in a suitable manner. In addition, under a condition that there is no contradiction, those skilled in the art may combine and combine different embodiments or examples described in this specification and features of different embodiments or examples.

In addition, the terms "first" and "second" are used only for descriptive purposes and cannot be understood as indicating or implying relative importance or implicitly indicating the quantity of indicated technical features. Thus, features limited by "first" and "second" may explicitly or implicitly include at least one such feature. In the description of the present disclosure, "a plurality of" means two or more, unless otherwise expressly and specifically defined.

The above descriptions are merely specific embodiments of the present disclosure, but the scope of the present disclosure is not limited thereto. Any person skilled in the art familiar with the technical field may readily conceive various modifications or substitutions within the technical scope disclosed by the present disclosure, and these modifications or substitutions shall all fall within the scope of the present disclosure. Therefore, the scope of the present disclosure shall be subject to the scope of the claims.

## Claims

1. A load lock, comprising:
a chamber body;
a first carrier plate and a second carrier plate oppositely arranged inside the chamber body, the first carrier plate and the second carrier plate being configured to carry wafers;
a driving mechanism connected to the second carrier plate and configured to drive the second carrier plate to move toward or away from the first carrier plate;
wherein, during a process in which the second carrier plate moves toward the first carrier plate, the first carrier plate and the second carrier plate are configured to clamp a wafer to a calibration position.

2. The load lock according to claim 1, further comprising:
a stop member located between the first carrier plate and the second carrier plate, wherein the stop member is configured to abut against the second carrier plate when the second carrier plate moves toward the first carrier plate until the first carrier plate and the second carrier plate clamp the wafer to the calibration position.

3. The load lock according to claim 1 or 2, wherein an upper surface of the first carrier plate includes a first limiting surface, an upper surface of the second carrier plate includes a second limiting surface, and in a case where the first carrier plate and the second carrier plate clamp the wafer to the calibration position, both the first limiting surface and the second limiting surface abut against a peripheral edge of the wafer.

4. The load lock according to claim 1, wherein the upper surface of the first carrier plate and the upper surface of the second carrier plate are each in a fan-ring shape, the upper surface of the first carrier plate and the upper surface of the second carrier plate form an annular bearing surface having a notch, and the annular bearing surface inclines inwardly and downwardly along a radial direction of the annular bearing surface and is configured to support an edge region of a lower surface of the wafer.

5. The load lock according to claim 1, wherein there are a plurality of first carrier plates and a plurality of second carrier plates, the plurality of first carrier plates and the plurality of second carrier plates are spaced apart along a vertical direction, and the plurality of first carrier plates correspond one-to-one to the plurality of second carrier plates and are configured to carry a plurality of wafers.

6. The load lock according to claim 1, wherein the driving mechanism includes a cylinder and a telescopic rod, a first end of the telescopic rod is connected to the cylinder, a second end of the telescopic rod is connected to the second carrier plate, and the cylinder drives the telescopic rod to extend and retract so as to drive the second carrier plate to move; or
the driving mechanism includes a motor and a motor shaft, a first end of the motor shaft is connected to the motor, a second end of the motor shaft is connected to the second carrier plate, and the motor drives the motor shaft to extend and retract so as to drive the second carrier plate to move.

7. Semiconductor process equipment, comprising an Equipment Front-End Module, a transport chamber, a process chamber, and at least one group of load locks according to any one of claims 1 to 6;
wherein each group of load locks includes a first load lock and a second load lock adjacently arranged along a horizontal direction, and the first load lock and the second load lock are both connected between the Equipment Front-End Module and the transport chamber;
the process chamber is connected to the transport chamber, and a plurality of bases are arranged inside the process chamber;
in a case where the first carrier plate and the second carrier plate in the first load lock clamp a wafer to a calibration position, and the first carrier plate and the second carrier plate in the second load lock clamp a wafer to the calibration position, a relative positional relationship between the wafer in the first load lock and the wafer in the second load lock is adapted to a relative positional relationship between two adjacent bases.

8. The semiconductor process equipment according to claim 7, wherein there are two groups of load locks, and the two groups of load locks are stacked along a vertical direction, one group of load locks is used as an intermediate load lock for transferring the wafer from the Equipment Front-End Module to the transport chamber, and another group of load locks is used as an intermediate load lock for transferring the wafer from the transport chamber to the Equipment Front-End Module.

9. A wafer calibration method, applied to the load lock according to any one of claims 1 to 6, the load lock being provided with a gas inlet assembly and a gas evacuation assembly, the method comprising:
when the wafer is placed on the first carrier plate and the second carrier plate in the load lock, controlling the gas inlet assembly to introduce gas into an interior of the chamber body of the load lock or controlling the gas evacuation assembly to evacuate gas from the interior of the chamber body of the load lock;
during a process of controlling gas introduction or gas evacuation, controlling the driving mechanism to drive the second carrier plate to move toward the first carrier plate.

10. The method according to claim 9, further comprising:
after controlling the wafer to move out of the load lock, controlling the driving mechanism to drive the second carrier plate to move toward a direction away from the first carrier plate.
